(19) Europäisches Patentamt
European Patent Office
Office européen des brevets

(11) EP 4 697 910 A1

(12) # EUROPEAN PATENT APPLICATION
published in accordance with Art. 153(4) EPC

(43) Date of publication:
**18.02.2026 Bulletin 2026/08**

(21) Application number: **23933585.4**

(22) Date of filing: **26.05.2023**

(51) International Patent Classification (IPC):
***H10K 50/18*** *(2023.01)*

(52) Cooperative Patent Classification (CPC):
**H10K 85/636; H10K 50/11; H10K 50/17; H10K 50/18; H10K 85/631;** H10K 50/181; H10K 85/6572; H10K 2101/30; H10K 2101/40; H10K 2102/351

(86) International application number:
**PCT/CN2023/096604**

(87) International publication number:
**WO 2024/216710 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.04.2023 CN 202310433121**

(71) Applicant: **Wuhan China Star Optoelectronics Semiconductor Display Technology Co., Ltd.**
**Wuhan, Hubei 430079 (CN)**

(72) Inventor: **XIA, Guoqi**
**Wuhan, Hubei 430079 (CN)**

(74) Representative: **Nederlandsch Octrooibureau**
**P.O. Box 29720**
**2502 LS The Hague (NL)**

(54) **ORGANIC LIGHT-EMITTING DISPLAY PANEL**

(57) Organic light-emitting display panel are provided. The organic light-emitting display panel includes a substrate, a first electrode, a hole injection layer, a hole transport layer, a first electron blocking layer, a second electron blocking layer, a light-emitting layer, an electron transport layer, an electron injection layer, and a second electrode sequentially stacked in layers. A hole mobility of the first electron blocking layer is greater than a hole mobility of the second electron blocking layer. A highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer.

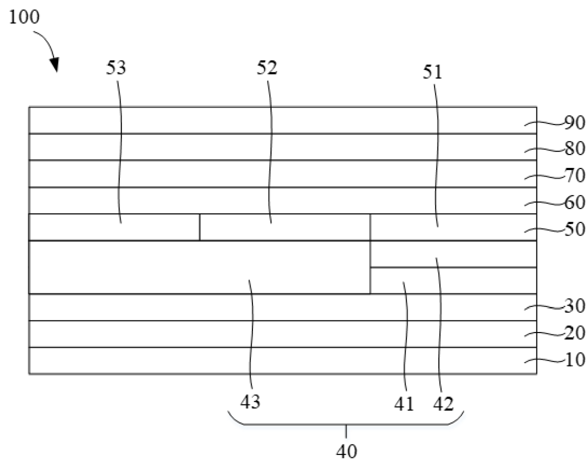


FIG. 1

EP 4 697 910 A1

## Description

TECHNICAL FIELD

The present application relates to the field of display technologies, and in particular, to organic light-emitting display panels.

BACKGROUND

Organic light-emitting diode (OLED) displays have characteristics of self-illumination, fast response, wide viewing angle, etc., and have a very broad application prospect, and have gradually replaced the position of liquid crystal displays in the field of display.

In an OLED display panel, a pixel generally includes three subpixels of blue, green, and red, and the three subpixels are driven by a backplane drive circuit to display different images. The three subpixels emit different colors of light because different organic materials are used. Due to the use of different organic materials, the three subpixels have different electrical properties (e.g., resistance, capacitance, turn-on voltage, etc.). Differences in electrical properties of the subpixels often leads to a series of display problems in the display panel. One of the more significant differences is in a change amplitude of the capacitance before and after an operation of the three subpixels. In general, after the OLED device is working and aging for a period of time, the capacitance of the pixel will become smaller.

TECHNICAL PROBLEMS

In view of this, the present application provides organic light-emitting display panels capable of reducing the change amplitude of the capacitance of the pixel.

TECHNICAL SOLUTIONS

The present application provides an organic light-emitting display panels, which includes a substrate, a first electrode disposed on a side of the substrate, a hole injection layer disposed on a side of the first electrode away from the substrate, a hole transport layer disposed on a side of the hole injection layer away from the substrate, a first electron blocking layer disposed on a side of the hole transport layer away from the substrate, a second electron blocking layer disposed on a side of the first electron blocking layer away from the substrate, a light-emitting layer disposed on a side of the second electron blocking layer away from the substrate, an electron transport layer disposed on a side of the light-emitting layer away from the substrate, an electron injection layer disposed on a side of the electron transport layer away from the substrate, and a second electrode disposed on a side of the electron injection layer away from the substrate. A hole mobility of the first electron blocking layer is greater than a hole mobility of the second electron blocking layer, a highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer.

Optionally, a first triple excited state energy level of the first electron blocking layer is greater than a first triple excited state energy level of the second electron blocking layer, and the first triple excited state energy level of the second electron blocking layer is greater than a first triple excited state energy level of the light-emitting layer.

Optionally, a difference between the first triple excited state energy level of the first electron blocking layer and the first triple excited state energy level of the second electron blocking layer is greater than or equal to 0.1 eV; and a difference between the first triple excited state energy level of the second electron blocking layer and the first triple excited state energy level of the light-emitting layer is greater than or equal to 0.1 eV.

Optionally, a difference between the HOMO energy level of the first electron blocking layer and the HOMO energy level of the second electron blocking layer is less than or equal to 0.2 eV, and a difference between the HOMO energy level of the second electron blocking layer and the HOMO energy level of the light-emitting layer is less than or equal to 0.2 eV.

Optionally, the HOMO energy level of the first electron blocking layer ranges between -5.4 eV and -5.6 eV, and the HOMO energy level of the second electron blocking layer ranges between -5.5 eV and -5.7 eV.

Optionally, a HOMO energy level of the hole transport layer is greater than or equal to the HOMO energy level of the first electron blocking layer.

Optionally, a difference between the HOMO energy level of the hole transport layer and the HOMO energy level of the first electron blocking layer is less than or equal to a difference between the HOMO energy level of the first electron blocking layer and the HOMO energy level of the second electron blocking layer.

Optionally, a difference between the HOMO energy level of the hole transport layer and the HOMO energy level of the first electron blocking layer is less than or equal to 0.2 eV.

Optionally, a carrier tolerance of the first electron blocking layer is less than a carrier tolerance of the second electron blocking layer.

Optionally, a thickness of the first electron blocking layer is greater than a thickness of the second electron blocking layer.

Optionally, on a condition that a brightness of the light-emitting layer decays to 95% of an initial brightness, a first change amplitude of a capacitance between the first electrode and the second electrode is less than or equal to 5%, and

$$\omega_1=\left(1-\frac{b}{a}\right)\times 100\%,$$

where $\omega_1$ is the first change amplitude of the capacitance between the first electrode and the second electrode, a is an initial value of the capacitance between the first electrode and the second electrode, and b is a measured value of the capacitance between the first electrode and the second electrode on the condition that the brightness of the light-emitting layer decays to 95% of the initial brightness.

Optionally, on a condition that the light-emitting layer works more than 120h, a change amplitude of a second capacitance between the first electrode and the second electrode is less than or equal to 10%, and

$$\omega_2=\left(1-\frac{d}{c}\right)\times 100\%$$

where $\omega_2$ is the change amplitude of the second capacitance between the first electrode and the second electrode, c is an initial value of the capacitance between the first electrode and the second electrode, and d is a measured value of the capacitance between the first electrode and the second electrode on the condition that the light-emitting layer works more than 120h.

Optionally, the light-emitting layer generates a green light.

Optionally, the hole mobility of the first electron blocking layer is greater than or equal to $10^{-5}$ $cm^2V^{-1}s^{-1}$, and the hole mobility of the second electron blocking layer is greater than or equal to $10^{-6}$ $cm^2V^{-1}s^{-1}$.

Optionally, a material of the first electron blocking layer and a material of the second electron blocking layer are independently selected from one of the following compounds,

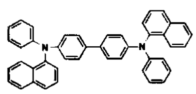
NPB

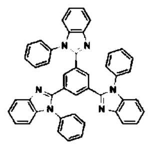
TPBi

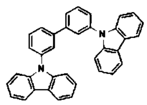
MCBP

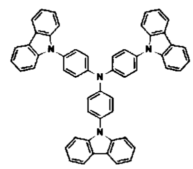
TCTA

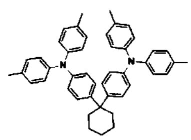
TAPC

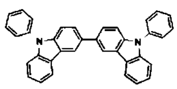
BCzPh

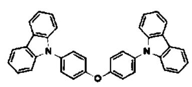
CBPE

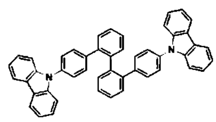
4CzPBP

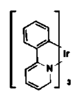
Ir(ppy)₃

Optionally, the material of the first electron blocking layer is TCTA, TAPC, or BCzPh, and the material of the second electron blocking layer is CBPE or 4CzPBP.

The present application also provides an organic light-emitting display panel, including:

a substrate;

a first electrode disposed on a side of the substrate;

a hole injection layer disposed on a side of the first electrode away from the substrate;

a hole transport layer disposed on a side of the hole injection layer away from the substrate;

a first electron blocking layer disposed on a side of the hole transport layer away from the substrate;

a second electron blocking layer disposed on a side of the first electron blocking layer away from the substrate;

a light-emitting layer disposed on a side of the second electron blocking layer away from the substrate;

an electron transport layer disposed on a side of the light-emitting layer away from the substrate;

an electron injection layer disposed on a side of the electron transport layer away from the substrate; and

a second electrode disposed on a side of the electron injection layer away from the substrate,

herein, a hole mobility of the first electron blocking layer is greater than a hole mobility of the second electron blocking layer, a highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer;

a material of the first electron blocking layer and a material of the second electron blocking layer are independently selected from one of the following compounds,

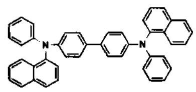
NPB

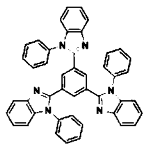
TPBi

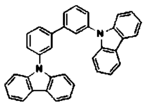
MCBP

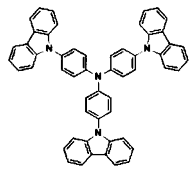
TCTA

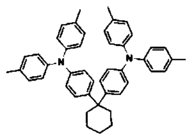
TAPC

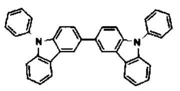
BCzPh

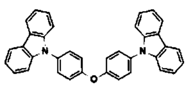
CBPE

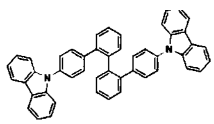
4CzPBP

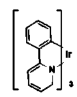
Ir(ppy)₃

;

and

on a condition that a brightness of the light-emitting layer decays to 95% of an initial brightness, a first change amplitude of a capacitance between the first electrode and the second electrode is less than or equal to 5%, and

$$\omega_1=\left(1-\frac{b}{a}\right)\times 100\%$$

,

where $\omega_1$ is the first change amplitude of the capacitance between the first electrode and the second electrode, a is an initial value of the capacitance between the first electrode and the second electrode, and b is a measured value of the capacitance between the first electrode and the second electrode on the condition that the brightness of the light-emitting layer decays to 95% of the initial brightness; or

on a condition that the light-emitting layer works more than 120h, a change amplitude of a second capacitance between the first electrode and the second electrode is less than or equal to 10%, and

$$\omega_2=\left(1-\frac{d}{c}\right)\times 100\%$$

where $\omega_2$ is the change amplitude of the second capacitance between the first electrode and the second electrode, c is an initial value of the capacitance between the first electrode and the second electrode, and d is a measured value of the capacitance between the first electrode and the second electrode on the condition that the light-emitting layer works more than 120h.

BENEFICIAL EFFECTS

The present application provides organic light-emitting display panels. The organic light-emitting display panel includes a substrate, a first electrode, a hole injection layer, a hole transport layer, a first electron blocking layer, a second electron blocking layer, a light-emitting layer, an electron transport layer, an electron injection layer, and a second electrode sequentially stacked in layers. A hole mobility of the first electron blocking layer is greater than a hole mobility of the second electron blocking layer. A highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer. A double-layered electron blocking layer are provided in the device according to the present application, so as to improve a capacitance stability of a pixel, improve a carrier balance, and ensure a luminous efficiency of the device.

DESCRIPTION OF DRAWINGS

In order to more clearly illustrate the technical solutions in the present application, the following will be a brief introduction to the drawings required in the description of the embodiments. It is obvious that the drawings described below are only some embodiments of the present application. For those skilled in the art, without creative labor, other drawings may be obtained according to these drawings.

FIG 1 is a structural diagram of an organic light-emitting display panel provided according to an embodiment of the present application.

FIG. 2 (a) to FIG. 2 (c) are comparative figures of capacitance curves before and after aging in Example 1, Example 4, and Example 6 of the present application.

EMBODIMENTS OF THE INVENTION

The technical solutions in the embodiments of the present application will be clearly and completely described below in conjunction with the drawings in the embodiments of the present application. Apparently, the described embodiments are only some of the embodiments of the present application, not all of them. Based on the embodiments in the present application, all other embodiments obtained by those skilled in the art without making creative efforts belong to the scope of protection of the present application.

In the present application, unless otherwise expressly provided and qualified, a first feature "above" or "below" a second feature may include a direct contact between the first and second features, or may include an contact between the first and second features that are not directly connected but through additional feature between them. Moreover, the first feature "above", "upper", and "over" the second feature includes the first feature directly above or diagonally above the second feature, or simply indicates that the first feature is horizontal above the second feature. The first feature "below", "lower", and "under" the second feature includes the first feature directly below and diagonally below the second feature, or simply indicates that the first feature is horizontal below the second feature. In addition, the terms "first" and "second" are for descriptive purposes only and cannot be understood as indicating or implying relative importance or implicitly indicating the number of technical features indicated.

Organic light-emitting display panels are provided in the present application. The organic light-emitting display panel includes a substrate, a first electrode, a hole injection layer, a hole transport layer, a first electron blocking layer, a second electron blocking layer, a light-emitting layer, an electron transport layer, an electron injection layer, and a second electrode sequentially stacked in layers. A hole mobility of the first electron blocking layer is greater than a hole mobility of the second electron blocking layer. A highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer.

A double-layered electron blocking layer are provided in the device according to the present application, so as to relieve a damage of carriers to an interface between the electron blocking layer and the light-emitting layer, and improve a capacitance stability of a pixel. By adjusting a ratio of a thickness of the first electron blocking layer to a thickness of the second electron blocking layer, a drive voltage, luminous efficiency, and lifetime of the device might be adjusted. In addition, by arranging the first electron blocking layer with a high hole mobility on a side of the second electron blocking layer with a low hole mobility away from the light-emitting layer, the carrier balance can be improved and the luminous efficiency of the device can be guaranteed.

The following describes specific embodiments of the present application in conjunction with the accompanying drawings.

Referring to FIG. 1, an organic light-emitting display panel 100 according to an embodiment of the present

application includes an anode 10, a hole injection layer 20, a hole transport layer 30, an electron blocking layer 40, a light-emitting layer 50, a hole blocking layer 60, an electron transport layer 70, an optical coupling layer 80, and a cathode 90 sequentially stacked in layers. Organic light-emitting devices in the organic light-emitting display panel 100 in the embodiment are upright OLED devices. It is understood that the organic light-emitting devices of the organic light-emitting display panel 100 in other embodiments of the present application may also be inverted OLED devices.

The anode 10 and the cathode 90 are independently selected from metal oxide doped particle electrodes, metal and metal oxide composite electrodes, graphene electrodes, carbon nanotube electrodes, metal electrodes, or alloy electrodes. A metal of the oxide doped particle electrode is one or more selected from indium-doped tin oxide, fluorine-doped tin oxide, antimony-doped tin oxide, aluminum-doped zinc oxide, gallium-doped zinc oxide, indium-doped zinc oxide, magnesium-doped zinc oxide, and aluminum-doped magnesium oxide. A material of the metal and metal oxide composite electrode is selected from AZO/Ag/AZO, AZO/Al/AZO, ITO/Ag/ITO, ITO/AL/ITO, ZnO/Ag/ZnO, ZnO/Al/ZnO, TiO2/Ag/TiO2, TiO2/Al/TiO2, ZnS/Ag/ZnS, or ZnS/Al/ZnS. A material of the metal electrode is one or more selected from Ag, Al, Cu, Mo, Au, Pt, Si, Ca, Mg, and Ba.

The hole injection layer 20 is a layer for injecting the holes from the anode 10. A material of the hole injection layer 20 is preferably a compound which has a capability of transporting the holes. Specific examples of a hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

The hole transport layer 30 is a layer that receives the holes from the hole injection layer 20 and transports the holes to the light-emitting layer 50. A hole transport material of the hole transport layer 30 is suitably a material having a large hole mobility, which can receive the holes from the anode 10 or the hole injection layer 20 and transfer the holes to the light-emitting layer 50. Specific examples thereof include an arylamine-based organic material, a conductive polymer, a block copolymer in which a conjugate portion and a non-conjugate portion are present together, and the like, but are not limited thereto.

The electron blocking layer 40 has a function of transporting the holes and blocking electrons from reaching the hole transport layer 30, thereby increasing a probability of recombining the electrons and the holes in the light-emitting layer 50. The electron blocking layer 40 includes a first electron blocking layer 41, a second electron blocking layer 42, and a third electron blocking layer 43. The light-emitting layer 50 includes a green light-emitting layer 51, a red light-emitting layer 52, and a blue light-emitting layer 53, which are disposed side by side on the electron blocking layer 40. The first electron blocking layer 41 and the second electron blocking layer 42 are stacked between the green light-emitting layer 51 and the anode 10. The first electron blocking layer 41 is disposed between the second electron blocking layer 42 and the anode 10. The third electron blocking layer 43 is disposed between the red light-emitting layer 52 and the anode 10, and between the blue light-emitting layer 53 and the anode 10. That is, a double-layered electron blocking layer is provided in a green pixel, and a single-layered electron blocking layer is provided in a red pixel and a blue pixel. A hole mobility of the first electron blocking layer 41 is greater than a hole mobility of the second electron blocking layer 42.

In related art, the organic light-emitting display panels are generally provided with a single-layered electron blocking layer. All the hole carriers injected from the anode accumulate at an interface between the electron blocking layer and the light-emitting layer, which causes greater damage to the interface between the electron blocking layer and the light-emitting layer, thereby resulting in poor performance of the device in capacitance reliability analysis experiments, that is, poor device stability. Among them, after a same working time, a change amplitude of a capacitance of the blue pixel relative to its initial value and a change amplitude of a capacitance of the red pixel relative to its initial value are small, and a change amplitude of a capacitance of the green pixel relative to its initial value is large. After a long period of operation, a threshold voltage at which the green pixel in the product is lit will become lower than threshold voltages at which the blue and red pixels are lit, thereby resulting in a problem of the product being green at low brightness (low grayscale). In the embodiment, the double-layered electron blocking layer 40 is provided in the green pixel, so the hole carriers injected from the anode 10 are dispersed at an interface between the first electron blocking layer 41 and the second electron blocking layer 42 and an interface between the second electron blocking layer 42 and the light-emitting layer 50, thereby reducing the hole carrier concentration, relieving the interface damage, and improving the capacitance stability. The problem of the display panel being green at a low voltage can be relieved by improving the capacitance stability of the green pixel.

It is understood that the double-layered electron blocking layer is only provided in the green pixel in the embodiment. In other embodiments of the present application, the double-layered electron blocking layer may also be provided in the red pixel or the green pixel, or the double-layered electron blocking layer may be provided in both or three of the red pixel, the green pixel, and the blue pixel, so as to improve the capacitance stability thereof.

On this basis, the first electron blocking layer 41 is functioned to adjust the driving voltage, and the second electron blocking layer 42 is functioned to adjust the luminous efficiency and the lifetime of the device. Specifically, since the first electron blocking layer 41 has a higher hole transport rate, so that a driving voltage may be reduced by increasing a proportion of the first electron blocking layer 41. Since the second electron blocking layer 42 has a lower the hole transport rate, so that an injection of the hole carriers into the light-emitting layer 50 may be limited by increasing a proportion of the

second electron blocking layer 42, thereby improving a carrier balance and improving the luminous efficiency. Thus, on a condition that a total thickness of the first electron blocking layer 41 and the second electron blocking layer 42 is kept unchanged, the driving voltage and the luminous efficiency can be adjusted by adjusting the relative thickness of the first electron blocking layer 41 and the second electron blocking layer 42. However, if the hole mobility of the second electron blocking layer 42 is too fast, it will affect the carrier balance in the electron blocking layer 40 and affect the luminous efficiency of the device. Thus, the first electron blocking layer 41 with a high hole mobility is arranged on a side of the second electron blocking layer 42 with a low hole mobility away from the light-emitting layer 50.

Optionally, the hole mobility of the first electron blocking layer 41 is greater than or equal to $10^{-5}$ $cm^2V^{-1}s^{-1}$, and the hole mobility of the second electron blocking layer 42 is greater than or equal to $10^{-6}$ $cm^2V^{-1}s^{-1}$. When the hole mobilities of the first electron blocking layer 41 and the second electron blocking layer 42 are too low, the driving voltage of the device will be high, which results in a product power consumption not meeting the standard.

Optionally, a material of the light-emitting layer 50 includes a host material and a guest material. In order to prevent the triplet state (T-state) excitons generated in the host material in the light-emitting layer 50 from spilling over to the electron blocking layer 40, a first triple excited state (T1) energy level of the first electron blocking layer 41, a T1 energy level of the second electron blocking layer 42, and a T1 energy level of the host material decrease.

Optionally, a difference between the T1 energy level of the first electron blocking layer 41 and the T1 energy level of the second electron blocking layer 42 is greater than or equal to 0.1 eV, and a difference between the T1 energy level of the second electron blocking layer 42 and the T1 energy level of the host material is greater than or equal to 0.1 eV. An effect of preventing T-state excitons from spilling over may not be sufficient when the difference between the T1 energy level of the first electron blocking layer 41 and the T1 energy level of second electron blocking layer 42 is less than 0.1eV.

Optionally, the T1 energy level of the host material is greater than or equal to 2.6 eV, the T1 energy level of the second electron blocking layer 42 is greater than or equal to 2.7 eV, and the T1 energy level of the first electron blocking layer 41 is greater than or equal to 2.8 eV. A T1 energy level of a green guest material (a dopant) is about 2.4 to 2.5 eV, so the T1 energy level of the green guest material can be limited to 2.6 eV.

Optionally, in order to facilitate carrier transport, a highest occupied molecular orbital (HOMO) energy level of the first electron blocking layer 41, a HOMO energy level of the second electron blocking layer 42, and a HOMO energy level of the host material decrease. A difference between the HOMO energy level of the first electron blocking layer 41 and the HOMO energy level of the second electron blocking layer 42 is less than or equal to 0.2 eV, and a difference between the HOMO energy level of the second electron blocking layer 42 and the HOMO energy level of the host material is less than or equal to 0.2 eV. The HOMO energy level of the first electron blocking layer ranges between -5.4 eV and -5.6 eV, and the HOMO energy level of the second electron blocking layer ranges between -5.5 eV and -5.7 eV.

Optionally, a HOMO energy level of the hole transport layer 30 is greater than or equal to the HOMO energy level of the first electron blocking layer 41. In order to facilitate carrier transport, the HOMO energy level of the first electron blocking layer 41, the HOMO energy level of the second electron blocking layer 42, and the HOMO energy level of the host material decrease. In practical applications, a difference between the HOMO energy level of the hole transport layer 30 and the HOMO energy level of the first electron blocking layer 41 is less than or equal to the difference between the HOMO energy level of the first electron blocking layer 41 and the HOMO energy level of the second electron blocking layer 42. The difference between the HOMO energy level of the hole transport layer 30 and the HOMO energy level of the first electron blocking layer 41 is less than or equal to 0.2 eV.

Optionally, a carrier tolerance of the first electron blocking layer 41 is less than a carrier tolerance of the second electron blocking layer 42. The carrier tolerance refers to a stability of the electron blocking layer relative to the carriers. The higher the carrier tolerance of the electron blocking layer, the smaller the change in performance under an impact of the carriers. When the electron blocking layer having a high carrier tolerance is used in the device, a change amplitude of the capacitance is small as the device increases with the use time. That is, the smaller the change amplitude of the capacitance of the device after the same aging time, the higher the carrier stability of the electron blocking layer. The holes injected from the anode 10 are mostly accumulated at the interface of the electron blocking layer 40 and the light-emitting layer 50, so the damage to the light-emitting layer 50 can be reduced by arranging the second electron blocking layer 42 having a higher carrier tolerance in direct contact with the light-emitting layer 50, thereby alleviating the decrease in the capacitance and improving the lifetime of the device.

Optionally, a thickness of the first electron blocking layer 41 is greater than a thickness of the second electron blocking layer 42. Preferred ranges and a ratio of the thickness of the first electron blocking layer 41 and the thickness of the second electron blocking layer 42 are not limited in the present application, and different ranges and ratio of the thicknesses may be set according to combinations of different materials. For example, in view of mass production, the thickness of the second electron blocking layer 42 may not exceed 200 angstroms. In addition, the second electron blocking layer 42 generally has a lower hole mobility, if the second electron blocking layer 42 is thicker than the first electron blocking layer 41, a voltage surge may occur. Therefore, the thickness of the first electron blocking layer 41 is designed to be greater than the thickness of the second electron blocking layer 42 to avoid excessive driving voltage.

Optionally, a material of the first electron blocking layer 41 and a material of the second electron blocking layer 42

are one independently selected from the following compounds,

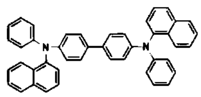
NPB
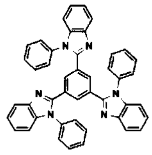
TPBi
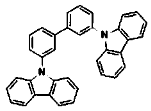
MCBP
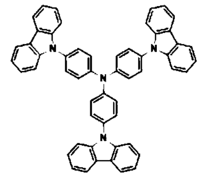
TCTA
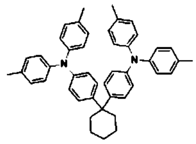
TAPC
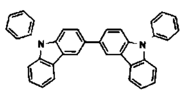
BCzPh
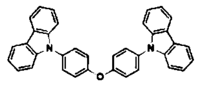
CBPE
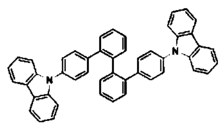
4CzPBP
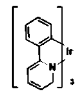
Ir(ppy)$_3$

Optionally, a material of a first blocking layer may include TCTA, TAPC, or BCzPh, and a material of a second blocking layer may include CBPE or 4CzPBP. Specifically, the material of the first electron blocking layer 41 may be TCTA, TAPC, or BCzPh, and the material of the second electron blocking layer 42 may be CBPE or 4CzPBP. The material of the first electron blocking layer 41 and the material of the second electron blocking layer 42 may further include other functional materials other than the electron blocking materials described above. Compared with TCTA, TAPC, and BCzPh, CBPE and 4CzPBP have higher luminous efficiency and smaller change amplitude (due to carrier tolerance) of the capacitance variation, so they are more suitable as the material of the second electron blocking layer 42.

A light-emitting material of the light-emitting layer 50 is a material which can receive the holes and the electrons transported from the hole transport layer and the electron transport layer, respectively, and combine the holes and the electrons to emit light in a visible ray region. Specific examples thereof include an 8-hydroxy-quinoline aluminum complex (Alq3), a carbazole-based compound, a dimerized styryl compound, BAlq; a 10-hydroxybenzoquinoline-metal compound, a benzoxazole, benzothiazole and benzimidazole-based compound; a poly(p-phenylenevinylene) (PPV)-based polymer, a spiro compound, polyfluorene, rubrene, and the like, but are not limited thereto.

The material of the light-emitting layer 50 may include a host material and a dopant material. The host material may be a fused aromatic ring derivative, a heterocyclic-containing compound, or the like. Specifically, the fused aromatic ring derivatives include anthracene derivatives, pyrene derivatives, naphthalene derivatives, pentacene derivatives, phenanthrene compounds, fluoranthene compounds, and the like; and the heterocyclic-containing compounds include carbazole derivatives, dibenzofuran derivatives, ladder-type furan compounds, pyrimidine derivatives, and the like, but are not limited thereto.

The dopant material, that is, a guest material may be an aromatic amine derivative, a styrylamine compound, a boron complex, a fluoranthene compound, a metal complex, or the like. Specifically, the aromatic amine derivative is a substituted or unsubstituted fused aromatic ring derivative having an arylamino group, and examples thereof include pyrene, anthracene, chrysene, periflanthene and the like, which have an arylamino group. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Furthermore, the metal complex includes an iridium complex, a platinum complex, and the like, but is not limited thereto.

Optionally, a luminescence mechanism of the blue light-emitting layer 53 is derived from an efficient blue emission induced by triplet-triplet annihilation (TTA).

The hole blocking layer 60 in a broad sense refers to having the function of the electron transport layer. The hole blocking layer 60 has functions of transporting the electrons and preventing the holes from reaching the electron transport layer, thereby increasing the probability of recombining electrons and holes in the light-emitting layer 50. A material of the hole blocking layer 60 may be a material of the electron transport layer according to the subsequent need.

The electron transport layer 70 is a layer which receives the electrons from the electron injection layer and transports the electrons to the light-emitting layer 50. an electron transport material of the electron transport layer 70 is suitably a material which can receive the electrons well from the cathode 90 and transfer the electrons to the light-emitting layer and has a large electron mobility. Specific examples thereof include: an Al complex of 8-hydroxyquinoline, a complex including Alq3, an organic radical compound, a hydroxyflavone-metal complex, and the like, but are not limited thereto.

The optical coupling layer 80 may further extract the light emitted by the light-emitting layer 50 to increase the luminous rate of the light-emitting layer 50. A material of the optical coupling layer 80 may be, for example, an organic material.

It is understood that the organic light-emitting display panel 100 of the present application may omit some non-essential film layers according to requirements, for example, the hole injection layer 20, the hole transport layer 30, the hole blocking layer 60, or the optical coupling layer 80. Film layers such as an electron transport layer and the like may also be added according to demand.

The organic light-emitting display panel 100 of the present application may only include the anode 10, the electron blocking layer 40, the light-emitting layer 50, and the cathode 90 sequentially stacked in layers.

The present application will be described below in conjunction with specific examples, but the present application is not limited to the following examples. It should be understood that the appended claims summarize the scope of the present application guided by the idea of the present application. Those skilled in the art should be aware that certain changes to each example of the present application will be covered by the spirit and scope of the claims of the present application.

Five different electron blocking materials are selected for research. The five materials are CBPE, 4CzPBP, TCTA, TAPC, and BCzPh, and green top electroluminescent devices in Comparative Examples 1 to 5 are prepared from these five materials.

Comparative Example 1

A green top electroluminescent device is manufactured, which includes following structures sequentially from bottom to top: a glass substrate; an anode 10, made of indium tin oxide (ITO) and having a thickness of 195 nm; a hole transport layer 30, made of NPB and having a thickness of 120nm; an electron blocking layer 40, made of TCTA and having a thickness of 40nm; a light-emitting layer 50, having a host material of MCBP and a dopant material of Ir(ppy)3 with a doping concentration of 6wt%, and having a thickness of 40nm; an electron transport layer 70, made of TPBi and having a thickness of 35nm; and a cathode 90, being a mixed electrode of Mg:Ag (having a mass ratio 1:10) and having a thickness of 12nm. When preparing the device, an evaporation rate of organic materials is 1A/s, and an evaporation rate of metal materials is 2A/s.

Comparative Example 2

The Comparative Example 2 differs from the Comparative Example 1 in that the electron blocking layer 40 is made of TAPC.

Comparative Example 3

The Comparative Example 3 differs from the Comparative Example 1 in that the electron blocking layer 40 is made of BCzPh.

Comparative Example 4

The Comparative Example 4 differs from the Comparative Example 1 in that the electron blocking layer 40 is made of CBPE.

Comparative Example 5

The Comparative Example 5 differs from the Comparative Example 1 in that the electron blocking layer 40 is made of 4CzPBP.

Parameters of a voltage @J10, a current efficiency (CE), a CIEx, LT95@50mA/$cm^2$, and a change amplitude of the capacitance are measured in the Comparative Examples 1 to 5.

The voltage @J10 refers to a voltage at a current density of 10 mA/$cm^2$ and is measured by the Keithley 2400 SourceMeter.

The CIEx refers to a color coordinates, and one purpose of detecting the CIEx is to prove that the device of the example is a green device, and another purpose is to allow all devices to be compared in the same color. The CIEx is measured by the PR 655 spectroscope.

The CE refers to a current efficiency, which is calculated by a test computer through a formula after a current information input from the Keithley 2400 SourceMeter and an optical information input from the PR 655 spectroscope are collected by test computer.

The LT95@50mA/$cm^2$ refers to a time during which a brightness of the light-emitting device decays to 95% of an initial brightness on a condition that a current density reaches 50mA/$cm^2$.

The capacitance is measured by the Zurich Instruments impedance analyzer.

Among them, a key indicator of the change amplitude of the capacitance is a change of peak capacitances before and after the OLED device is operated. The difference between the peak capacitances before and after operated may be characterized by two test condition methods as followings.

1. the first one is to measure an initial value of the capacitance, to apply a current with a current density of 50 mA/cm$^2$ (J50) to the device, to measure a post-value of the capacitance on a condition that the brightness decays to 95% of the initial brightness at a room temperature, and to compare with the initial value of the capacitance to obtain a difference between before and after operated.

2. the second one is to measure an initial value of the capacitance, to apply a current with a current density of 10 mA/cm$^2$ (J10) to the device, to measure a post-value of the capacitance on a condition of working more than 120 hours at a temperature of 85°C, and to compare with the initial value of the capacitance to obtain a difference between before and after operated.

A method for measuring the capacitance on the condition of the room temperature and J50 includes following steps:

measure of an initial value of the capacitance: measuring the initial value of the capacitance of the device by an impedance analyzer;

operation at a room temperature: applying a current with a current density of 50 mA/cm$^2$ to the device at a room temperature; and

measure of a post-value of the capacitance: taking out the above device after its brightness decays to 95% of its initial brightness, and measuring the post-value of the capacitance by the impedance analyzer.

An initial peak of the capacitance of the device is defined as a, a peak of the capacitance after operated on the condition of the room temperature and J50 is defined as b, and a change amplitude of the capacitance is defined as $\omega_1$, thus,

$$\omega_1=\left(1-\frac{b}{a}\right)\times 100\%.$$

A method for measuring the capacitance on the condition of a high temperature and J10 includes following steps:

measure of an initial value of the capacitance: measuring the initial value of the capacitance of the device by an impedance analyzer;

operation at a high temperature: applying a current with a current density of 10 mA/cm$^2$ to the device at a temperature of 85°C; and

measure of a post-value of the capacitance: taking out the above device after a continuous operation under the condition for 120 hours, and measuring the post-value of the capacitance by the impedance analyzer.

An initial peak of the capacitance of the device is defined as c, a peak of the capacitance after operated on the condition of the high temperature, J10, and continuous operation for 120 hours is defined as d, and a change amplitude of the capacitance is defined as $\omega_2$, thus,

$$\omega_2=\left(1-\frac{d}{c}\right)\times 100\%.$$

Methods for measuring the capacitance:
Measurement frequencies of the capacitance in the present application are 60Hz, 120Hz, 1KHz, and 10KHz.

Table 1 Performance measurement data in Comparative Examples 1 to 5

| Comparative Example | Electron blocking layer | Voltage @J10 | CE | CIEx | LT95 @50mA/cm$^2$ | $\omega_1$ | $\omega_2$ |
|---|---|---|---|---|---|---|---|
| Comparative Example 1 | TCTA | 3.6 | 163 | 0.237 | 71 | 45% | 56% |
| Comparative Example 2 | TAPC | 3.77 | 162 | 0.243 | 57 | 40% | 49% |
| Comparative Example 3 | BCzPh | 3.89 | 172 | 0.24 | 80 | 39% | 45% |
| Comparative Example 4 | CBPE | 3.96 | 177 | 0.241 | 89 | 30% | 32% |
| Comparative Example 5 | 4CzPBP | 4.07 | 182 | 0.236 | 85 | 25% | 30% |

Experimental results in Table 1 show that when the five electron blocking materials are separately used as the electron blocking layer, the capacitance before and after aging has undergone a large change. Among them, the change amplitudes of the capacitances of CBPE and 4CzPBP before and after aging are relatively small. Therefore, CBPE and 4CzPBP are suitably as the material of the second electron blocking layer, and TCTA, TAPC, and BCzPh are suitably as the material of the first electron blocking layer. Next, these five materials are used as materials of the electron blocking layer to make the green top electroluminescent devices in Examples 1 to 12.

Example 1

A green top electroluminescent device is manufactured, which includes following structures sequentially from bottom to top: a glass substrate; an anode 10, made of indium tin oxide (ITO) and having a thickness of 195nm; a hole transport layer, made of NPB and having a thickness of 120 nm; a first electron blocking layer, made of TCTA and having a thickness of 350 angstroms; a second electron blocking layer, made of CBPE and having a thickness of 50 angstroms; a light-emitting layer, having a host material of MCBP and a dopant material of Ir(ppy)3 with a doping concentration of 6wt%, and having a thickness of 40nm; an electron transport layer, made of TPBi and having a thickness of 35nm; and a cathode, being a mixed electrode of Mg:Ag(having a mass ratio 1:10), and having a thickness of 12nm. When preparing the device, an evaporation rate of organic materials is 1A/s, and an evaporation rate of metal materials is 2A/s.

Example 2

The Example 2 differs from Comparative Example 1 in that the first electron blocking layer 41 is made of TCTA and has a thickness of 300 angstroms, and the second electron blocking layer 42 is made of CBPE and has a thickness of 100 angstroms.

Example 3

The Example 3 differs from Comparative Example 1 in that the first electron blocking layer 41 is made of TCTA and has a thickness of 350 angstroms, and the second electron blocking layer 42 is made of 4CzPBP and has a thickness of 50 angstroms.

Example 4

The Example 4 differs from Comparative Example 1 in that the first electron blocking layer 41 is made of TCTA and has a thickness of 300 angstroms, and the second electron blocking layer 42 is made of 4CzPBP and has a thickness of 100 angstroms.

Example 5

The Example 5 differs from Comparative Example 1 in that the first electron blocking layer 41 is made of TAPC and has a thickness of 350 angstroms, and the second electron blocking layer 42 is made of CBPE and has a thickness of 50 angstroms.

Example 6

The Example 6 differs from Comparative Example 1 in that the first electron blocking layer 41 is made of TAPC and has a thickness of 300 angstroms, and the second electron blocking layer 42 is made of CBPE and has a thickness of 100 angstroms.

Example 7

The Example 7 differs from Comparative Example 1 in that the first electron blocking layer 41 is made of TAPC and has a thickness of 350 angstroms, and the second electron blocking layer 42 is made of 4CzPBP and has a thickness of 50 angstroms.

Example 8

The Example 8 differs from Comparative Example 1 in that the first electron blocking layer 41 is made of TAPC and has a thickness of 300 angstroms, and the second electron blocking layer 42 is made of 4CzPBP and has a thickness of 100 angstroms.

Example 9

The Example 9 differs from Comparative Example 1 in that the first electron blocking layer 41 is made of BCzPh and has a thickness of 350 angstroms, and the second electron blocking layer 42 is made of CBPE and has a thickness of 50 angstroms.

Example 10

The Example 10 differs from Comparative Example 1 in that the first electron blocking layer 41 is made of BCzPh and has a thickness of 300 angstroms, and the second electron blocking layer 42 is made of CBPE and has a thickness of 100 angstroms.

Example 11

The Example 11 differs from Comparative Example 1 in that the first electron blocking layer 41 is made of BCzPh and has a thickness of 350 angstroms, and the second electron blocking layer 42 is made of 4CzPBP and has a thickness of 50 angstroms.

Example 12

The Example 12 differs from Comparative Example 1 in that the first electron blocking layer 41 is made of BCzPh and has a thickness of 300 angstroms, and the second electron blocking layer 42 is made of 4CzPBP and has a thickness of 100 angstroms.

Table 2 Performance measurement data in Examples 1 to 12

| Example | Material/thickne ss of the first electron blocking layer | Material/thickne ss of the second electron blocking layer | Voltage @J10 | CE | CIEx | LT95 @50m A/$cm^2$ | $\omega_1$ | $\omega_2$ |
|---|---|---|---|---|---|---|---|---|
| Example 1 | TCTA/350 angstroms | CBPE/50 angstroms | 3.44 | 173 | 0.245 | 91 | 4% | 9% |
| Example 2 | TCTA/300 angstroms | CBPE/100 angstroms | 3.5 | 175 | 0.241 | 93 | 4% | 9% |
| Example 3 | TCTA/350 angstroms | 4CzPBP/50 angstroms | 3.46 | 178 | 0.24 | 99 | 2% | 8% |
| Example 4 | TCTA/300 angstroms | 4CzPBP/100 angstroms | 3.55 | 181 | 0.244 | 104 | 2% | 8% |
| Example 5 | TAPC/350 angstroms | CBPE/50 angstroms | 3.52 | 175 | 0.239 | 77 | 5% | 7% |
| Example 6 | TAPC/300 angstroms | CBPE/100 angstroms | 3.63 | 179 | 0.235 | 84 | 5% | 7% |
| Example 7 | TAPC/350 angstroms | 4CzPBP/50 angstroms | 3.55 | 182 | 0.24 | 89 | 3% | 7% |

(continued)

| Example | Material/thickne ss of the first electron blocking layer | Material/thickne ss of the second electron blocking layer | Voltage @J10 | CE | CIEx | LT95 @50m A/cm$^2$ | $\omega_1$ | $\omega_2$ |
|---|---|---|---|---|---|---|---|---|
| Example 8 | TAPC/300 angstroms | 4CzPBP/100 angstroms | 3.67 | 185 | 0.241 | 91 | 3% | 6% |
| Example 9 | BCzPh/350 angstroms | CBPE/50 angstroms | 3.6 | 171 | 0.244 | 94 | 4% | 8% |
| Example 10 | BCzPh/300 angstroms | CBPE/100 angstroms | 3.65 | 177 | 0.24 | 99 | 5% | 8% |
| Example 11 | BCzPh/350 angstroms | 4CzPBP/50 angstroms | 3.58 | 174 | 0.247 | 103 | 3% | 7% |
| Example 12 | BCzPh/300 angstroms | 4CzPBP/100 angstroms | 3.71 | 181 | 0.237 | 101 | 4% | 6% |

From the comparison of Table 1 and Table 2, it can be seen that compared with the Comparative Examples 1 to 5 using the single-layered electron blocking layer, in the Examples 1 to 12 using the double-layered electron blocking layer 40, the voltage @J10 decreases significantly, the LT95@50mA/cm$^2$ increases significantly, and the $\omega_1$ and the $\omega_2$ are significantly reduced. Among them, the $\omega_1$ is less than or equal to 5%, and the $\omega$2 is less than or equal to 10%. It shows that the double-layered blocking layer can reduce the driving voltage, improve the lifetime of the device, and improve the technical effect of capacitance stability.

In addition, referring to FIG. 2(a) to FIG. 2(c), in FIG. 2(a) to FIG. 2(c), the solid black line represents a capacitance curve before aging, and the dashed black line represents a capacitance curve after aging. FIG. 2 (a) to FIG. 2 (c) illustrate that the capacitance in Example 6 using the double-layered electron blocking layer decreases much slower than that in Example 1 and that in Example 4, demonstrating its capacitance stabilization effect.

The above is a detailed introduction to the embodiments of the present application. In this paper, specific examples are used to illustrate the principles and implementation methods of the present application. The descriptions of the above embodiments are only used to help understand the present application. At the same time, for those skilled in the art, according to the idea of the present application, there will be changes in the specific embodiment and the scope of application. In summary, the content of the present specification should not be understood as a restriction on the present application.

## Claims

1. An organic light-emitting display panel, comprising:

   a substrate;
   a first electrode disposed on a side of the substrate;
   a hole injection layer disposed on a side of the first electrode away from the substrate;
   a hole transport layer disposed on a side of the hole injection layer away from the substrate;
   a first electron blocking layer disposed on a side of the hole transport layer away from the substrate;
   a second electron blocking layer disposed on a side of the first electron blocking layer away from the substrate;
   a light-emitting layer disposed on a side of the second electron blocking layer away from the substrate;
   an electron transport layer disposed on a side of the light-emitting layer away from the substrate;
   an electron injection layer disposed on a side of the electron transport layer away from the substrate; and
   a second electrode disposed on a side of the electron injection layer away from the substrate,
   wherein a hole mobility of the first electron blocking layer is greater than a hole mobility of the second electron blocking layer, a highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer.

2. The organic light-emitting display panel according to claim 1, wherein a first triple excited state energy level of the first electron blocking layer is greater than a first triple excited state energy level of the second electron blocking layer, and the first triple excited state energy level of the second electron blocking layer is greater than a first triple excited state

energy level of the light-emitting layer.

3. The organic light-emitting display panel according to claim 2, wherein a difference between the first triple excited state energy level of the first electron blocking layer and the first triple excited state energy level of the second electron blocking layer is greater than or equal to 0.1 eV; and
a difference between the first triple excited state energy level of the second electron blocking layer and the first triple excited state energy level of the light-emitting layer is greater than or equal to 0.1 eV.

4. The organic light-emitting display panel according to claim 1, wherein a difference between the HOMO energy level of the first electron blocking layer and the HOMO energy level of the second electron blocking layer is less than or equal to 0.2 eV, and a difference between the HOMO energy level of the second electron blocking layer and the HOMO energy level of the light-emitting layer is less than or equal to 0.2 eV.

5. The organic light-emitting display panel according to claim 4, wherein the HOMO energy level of the first electron blocking layer ranges between -5.4 eV and -5.6 eV, and the HOMO energy level of the second electron blocking layer ranges between -5.5 eV and -5.7 eV.

6. The organic light-emitting display panel according to claim 1, wherein a HOMO energy level of the hole transport layer is greater than or equal to the HOMO energy level of the first electron blocking layer.

7. The organic light-emitting display panel according to claim 6, wherein a difference between the HOMO energy level of the hole transport layer and the HOMO energy level of the first electron blocking layer is less than or equal to a difference between the HOMO energy level of the first electron blocking layer and the HOMO energy level of the second electron blocking layer.

8. The organic light-emitting display panel according to claim 6, wherein a difference between the HOMO energy level of the hole transport layer and the HOMO energy level of the first electron blocking layer is less than or equal to 0.2 eV.

9. The organic light-emitting display panel according to claim 1, wherein a carrier tolerance of the first electron blocking layer is less than a carrier tolerance of the second electron blocking layer.

10. The organic light-emitting display panel according to claim 1, wherein a thickness of the first electron blocking layer is greater than a thickness of the second electron blocking layer.

11. The organic light-emitting display panel according to claim 1, wherein on a condition that a brightness of the light-emitting layer decays to 95% of an initial brightness, a first change amplitude of a capacitance between the first electrode and the second electrode is less than or equal to 5%, and

$$\omega_1=\left(1-\frac{b}{a}\right)\times 100\%,$$

where $\omega_1$ is the first change amplitude of the capacitance between the first electrode and the second electrode, a is an initial value of the capacitance between the first electrode and the second electrode, and b is a measured value of the capacitance between the first electrode and the second electrode on the condition that the brightness of the light-emitting layer decays to 95% of the initial brightness.

12. The organic light-emitting display panel according to claim 1, wherein on a condition that the light-emitting layer works more than 120h, a change amplitude of a second capacitance between the first electrode and the second electrode is less than or equal to 10%, and

$$\omega_2=\left(1-\frac{d}{c}\right)\times 100\%,$$

where $\omega_2$ is the change amplitude of the second capacitance between the first electrode and the second electrode, c is an initial value of the capacitance between the first electrode and the second electrode, and d is a measured value of

the capacitance between the first electrode and the second electrode on the condition that the light-emitting layer works more than 120h.

**13.** The organic light-emitting display panel according to claim 1, wherein the light-emitting layer generates a green light.

**14.** The organic light-emitting display panel according to claim 1, wherein the hole mobility of the first electron blocking layer is greater than or equal to $10^{-5}$ $cm^2V^{-1}s^{-1}$, and the hole mobility of the second electron blocking layer is greater than or equal to $10^{-6}$ $cm^2V^{-1}s^{-1}$.

**15.** The organic light-emitting display panel according to claim 1, wherein a material of the first electron blocking layer and a material of the second electron blocking layer are independently selected from one of the following compounds,

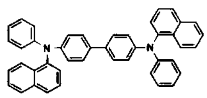
NPB

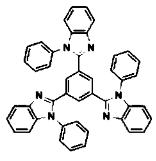
TPBi

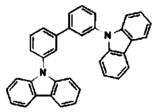
MCBP

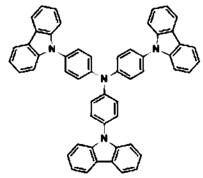
TCTA

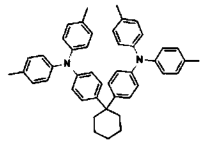
TAPC

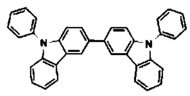
BCzPh

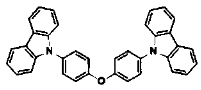
CBPE

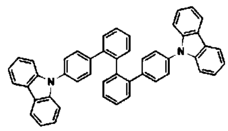
4CzPBP

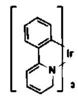
Ir(ppy)₃

**16.** The organic light-emitting display panel according to claim 15, wherein the material of the first electron blocking layer is TCTA, TAPC, or BCzPh, and the material of the second electron blocking layer is CBPE or 4CzPBP.

**17.** An organic light-emitting display panel, comprising:

a substrate;
a first electrode disposed on a side of the substrate;
a hole injection layer disposed on a side of the first electrode away from the substrate;
a hole transport layer disposed on a side of the hole injection layer away from the substrate;
a first electron blocking layer disposed on a side of the hole transport layer away from the substrate;
a second electron blocking layer disposed on a side of the first electron blocking layer away from the substrate;
a light-emitting layer disposed on a side of the second electron blocking layer away from the substrate;
an electron transport layer disposed on a side of the light-emitting layer away from the substrate;
an electron injection layer disposed on a side of the electron transport layer away from the substrate; and
a second electrode disposed on a side of the electron injection layer away from the substrate,
wherein a hole mobility of the first electron blocking layer is greater than a hole mobility of the second electron blocking layer, a highest occupied molecular orbital (HOMO) energy level of the first electron blocking layer is greater than a HOMO energy level of the second electron blocking layer, and the HOMO energy level of the second electron blocking layer is greater than a HOMO energy level of the light-emitting layer;
a material of the first electron blocking layer and a material of the second electron blocking layer are independently selected from one of the following compounds,

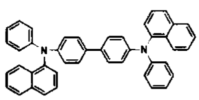
NPB

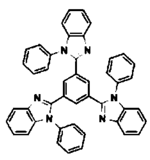
TPBi

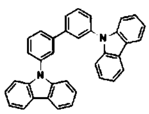
MCBP

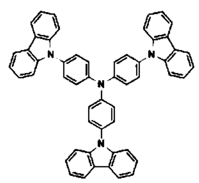
TCTA

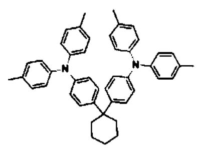
TAPC

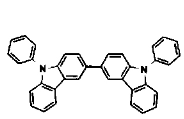
BCzPh

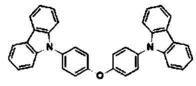
CBPE

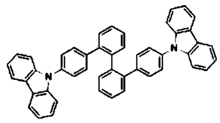
4CzPBP

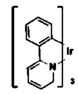
Ir(ppy)₃

;

and

on a condition that a brightness of the light-emitting layer decays to 95% of an initial brightness, a first change amplitude of a capacitance between the first electrode and the second electrode is less than or equal to 5%, and

$$\omega_1=\left(1-\frac{b}{a}\right)\times 100\% ,$$

where $\omega_1$ is the first change amplitude of the capacitance between the first electrode and the second electrode, a is an initial value of the capacitance between the first electrode and the second electrode, and b is a measured value of the capacitance between the first electrode and the second electrode on the condition that the brightness of the light-emitting layer decays to 95% of the initial brightness; or

on a condition that the light-emitting layer works more than 120h, a change amplitude of a second capacitance between the first electrode and the second electrode is less than or equal to 10%, and

$$\omega_2=\left(1-\frac{d}{c}\right)\times 100\% ,$$

where $\omega_2$ is the change amplitude of the second capacitance between the first electrode and the second electrode, c is an initial value of the capacitance between the first electrode and the second electrode, and d is a measured value of the capacitance between the first electrode and the second electrode on the condition that the light-emitting layer works more than 120h.

**18.** The organic light-emitting display panel according to claim 17, wherein a first triple excited state energy level of the first electron blocking layer is greater than a first triple excited state energy level of the second electron blocking layer, and the first triple excited state energy level of the second electron blocking layer is greater than a first triple excited state energy level of the light-emitting layer.

**19.** The organic light-emitting display panel according to claim 18, wherein a difference between the first triple excited state energy level of the first electron blocking layer and the first triple excited state energy level of the second electron blocking layer is greater than or equal to 0.1 eV; and

a difference between the first triple excited state energy level of the second electron blocking layer and the first triple excited state energy level of the light-emitting layer is greater than or equal to 0.1 eV.

**20.** The organic light-emitting display panel according to claim 17, wherein a difference between the HOMO energy level of the first electron blocking layer and the HOMO energy level of the second electron blocking layer is less than or equal to 0.2 eV, and a difference between the HOMO energy level of the second electron blocking layer and the HOMO energy level of the light-emitting layer is less than or equal to 0.2 eV.

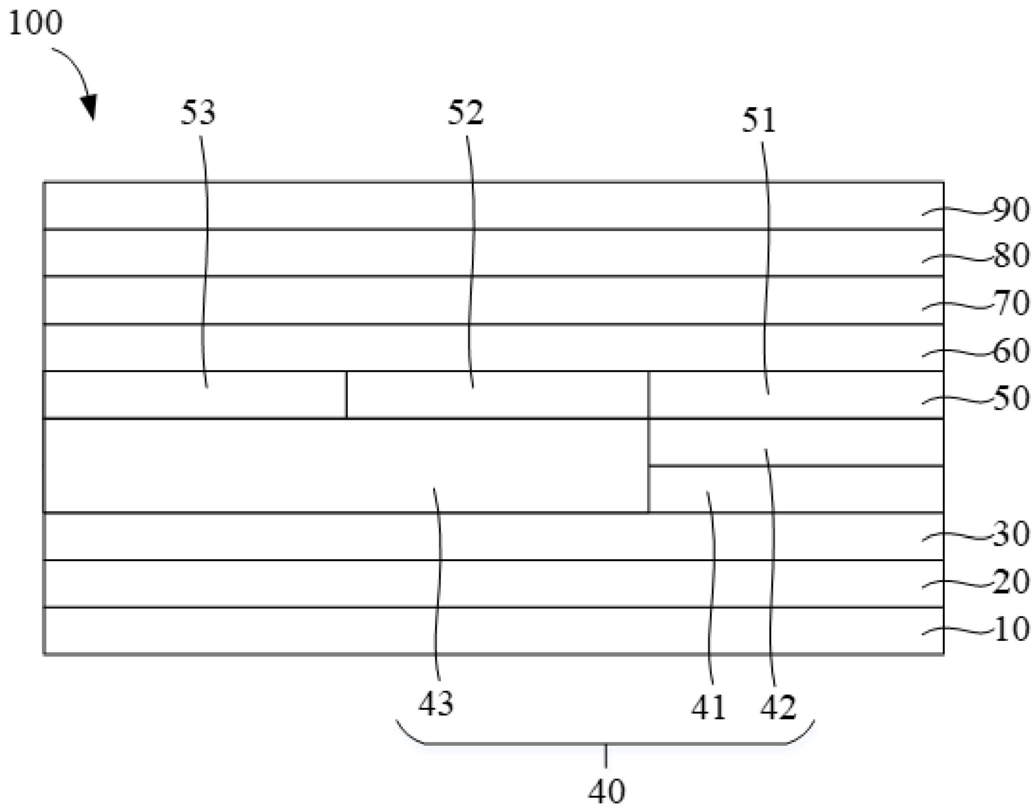
100
53
52
51
90
80
70
60
50
30
20
10
43
41
42
40

FIG. 1

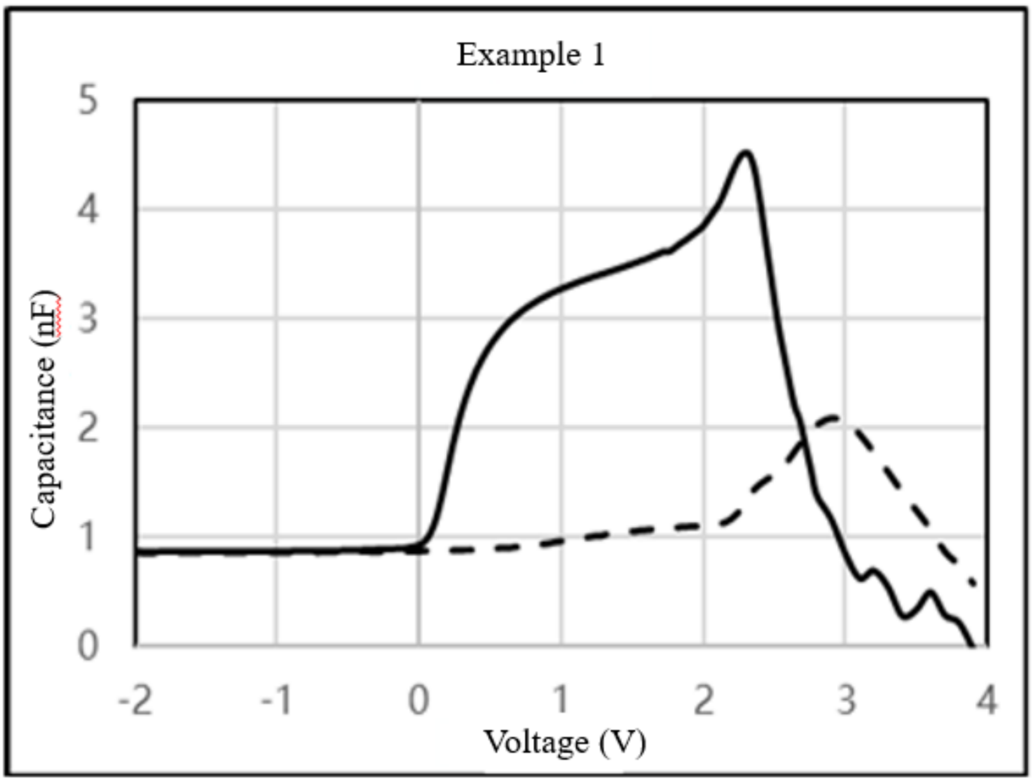
Example 1
Capacitance (nF)
Voltage (V)
5
4
3
2
1
0
-2
-1
0
1
2
3
4

FIG. 2(a)

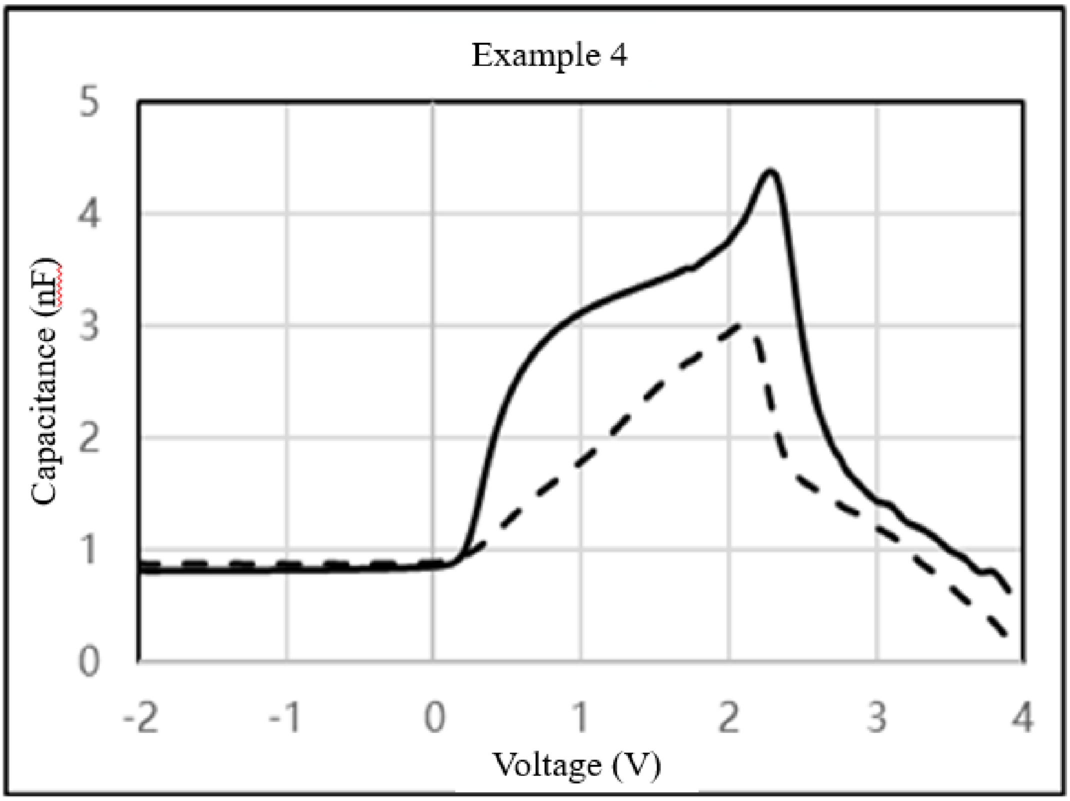
Example 4
Capacitance (nF)
5
4
3
2
1
0
-2
-1
0
1
2
3
4
Voltage (V)

FIG. 2(b)

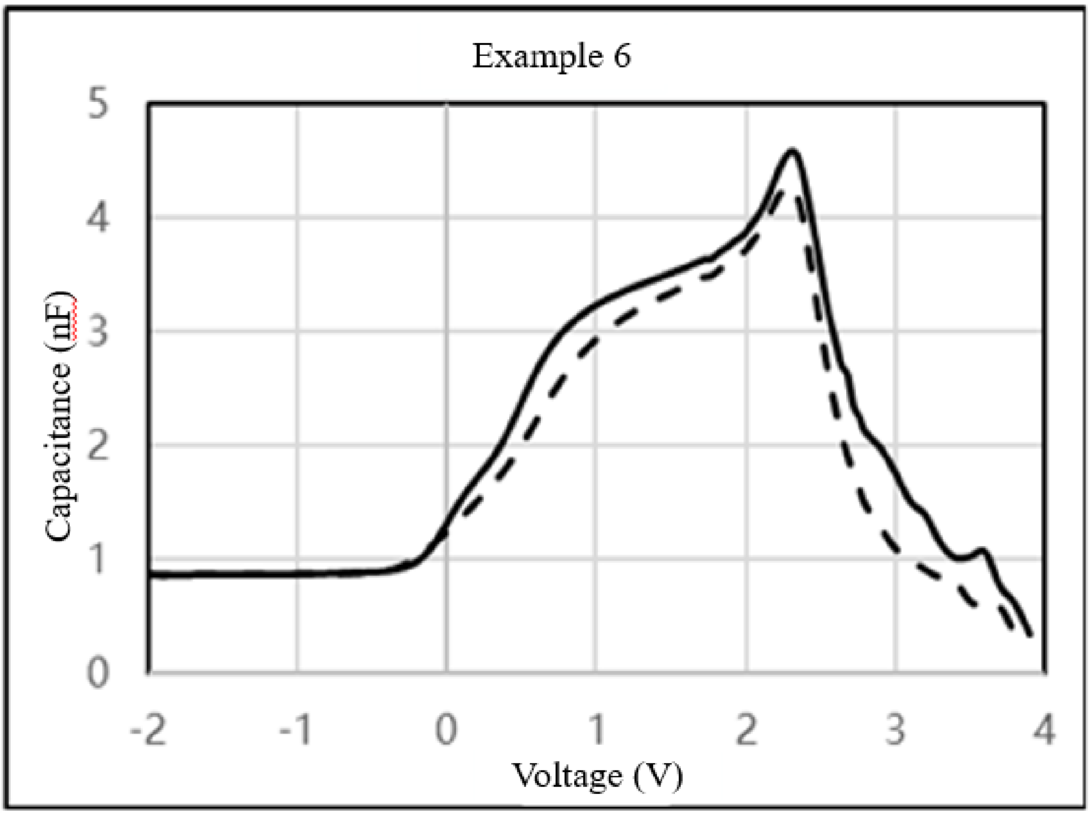
Example 6
Capacitance (nF)
5
4
3
2
1
0
-2
-1
0
1
2
3
4
Voltage (V)

FIG. 2(c)

## INTERNATIONAL SEARCH REPORT

International application No. **PCT/CN2023/096604**

**A. CLASSIFICATION OF SUBJECT MATTER**

H10K50/18(2023.01)i

According to International Patent Classification (IPC) or to both national classification and IPC

**B. FIELDS SEARCHED**

Minimum documentation searched (classification system followed by classification symbols)

IPC:H10K,H01L

Documentation searched other than minimum documentation to the extent that such documents are included in the fields searched

Electronic data base consulted during the international search (name of data base and, where practicable, search terms used)

DWPI, WPABS, CNTXT, ENTXT, ENTXTC, CNABS, CNKI, IEEE: 有机, 发光, 显示, 面板, 基板, 电极, 空穴, 注入, 电子, 阻挡, 传输, 能级, organic, light, emitting, display, panel, wafer, substrate, electrode, hole, inject, electron, barrier, transport, level

**C. DOCUMENTS CONSIDERED TO BE RELEVANT**

| Category* | Citation of document, with indication, where appropriate, of the relevant passages | Relevant to claim No. |
|---|---|---|
| A | CN 113437231 A (YUNGU (GU'AN) TECHNOLOGY CO., LTD.) 24 September 2021 (2021-09-24)<br>description, paragraphs 0031-0122, and figures 1-6 | 1-20 |
| A | CN 115867063 A (KUNSHAN NEW FLAT PANEL DISPLAY TECHNOLOGY CENTER CO., LTD.) 28 March 2023 (2023-03-28)<br>entire document | 1-20 |
| A | JP 2017054870 A (HITACHI, LTD.) 16 March 2017 (2017-03-16)<br>entire document | 1-20 |

☐ Further documents are listed in the continuation of Box C.

☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **24 October 2023** | **28 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**
**Information on patent family members**

International application No.
**PCT/CN2023/096604**

| Patent document cited in search report | | | Publication date (day/month/year) | Patent family member(s) | | | Publication date (day/month/year) |
|---|---|---|---|---|---|---|---|
| CN | 113437231 | A | 24 September 2021 | CN | 113437231 | B | 08 November 2022 |
| CN | 115867063 | A | 28 March 2023 | | None | | |
| JP | 2017054870 | A | 16 March 2017 | | None | | |

Form PCT/ISA/210 (patent family annex) (July 2022)